(19) Europäisches Patentamt
European Patent Office
Office européen des brevets

(11) **EP 4 756 451 A1**

(12) **EUROPEAN PATENT APPLICATION**
published in accordance with Art. 153(4) EPC

(43) Date of publication:
**10.06.2026 Bulletin 2026/24**

(21) Application number: **24880225.8**

(22) Date of filing: **10.10.2024**

(51) International Patent Classification (IPC):
*G01R 31/385* (2019.01)    *G01R 19/165* (2006.01)
*H01M 10/42* (2006.01)    *H01M 10/44* (2006.01)
*H01M 10/04* (2006.01)

(52) Cooperative Patent Classification (CPC):
**G01R 19/165; G01R 31/385; H01M 10/04;
H01M 10/42; H01M 10/44;** Y02E 60/10; Y02P 70/50

(86) International application number:
**PCT/KR2024/096241**

(87) International publication number:
**WO 2025/084889 (24.04.2025 Gazette 2025/17)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **16.10.2023 KR 20230137347**

(71) Applicant: **LG Energy Solution, Ltd.
Seoul 07335 (KR)**

(72) Inventors:
• **SEO, Ja Young
Daejeon 34122 (KR)**
• **LEE, Dong Hun
Daejeon 34122 (KR)**
• **KIM, Dae Hong
Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **METHOD FOR MANUFACTURING SECONDARY BATTERY**

(57)    Example embodiments provide a secondary battery manufacturing method. The method includes first-order approximating an open circuit voltage (OCV) relative to a square root of time, based on a measured OCV, and evaluating the quality of a battery cell based on the first-order approximation.

[FIG. 2]

P150

```
┌──────────────────────────────────────────────────────┐
│   MEASURE OCV OF BATTERY CELL AT FIRST TIME POINT      │──── P151
└──────────────────────────────────────────────────────┘
                            │
                            ▼
┌──────────────────────────────────────────────────────┐
│   MEASURE OCV OF BATTERY CELL AT SECOND TIME POINT     │──── P153
└──────────────────────────────────────────────────────┘
                            │
                            ▼
┌──────────────────────────────────────────────────────┐
│       CALCULATE OCV OF BATTERY CELL AT FIRST TIME      │
│   POINT AND OCV OF BATTERY CELL AT THIRD TIME POINT    │──── P155
└──────────────────────────────────────────────────────┘
                            │
                            ▼
┌──────────────────────────────────────────────────────┐
│        COMPARE CALCULATED OCV OF BATTERY CELL          │
│         AT FIRST TIME POINT WITH CALCULATED            │──── P157
│     OCV OF BATTERY CELL AT THIRD TIME POINT            │
└──────────────────────────────────────────────────────┘
```

EP 4 756 451 A1

**Description**

[Technical Field]

The present invention relates to a secondary battery manufacturing method. The present application claims the benefit of priority based on Korean Patent Application No. 10-2023-0137347, filed on October 16, 2023, and the entire contents of the Korean patent application is incorporated herein by reference.

[Background Art]

Secondary batteries can be charged and discharged a plurality of times unlike primary batteries. Secondary batteries have been widely used as energy sources for various types of wireless devices such as handsets, laptop computers, and cordless vacuum cleaners. Recently, a main use of secondary batteries is moving from mobile devices to mobility, as manufacturing costs per unit capacity of secondary batteries drastically decrease due to improved energy density and economies of scale and a range of battery electric vehicles (BEVs) increases to the same level as fuel vehicles.
A secondary battery is manufactured by an electrode process, an assembly process, and an activation process. In the electrode process, an electrode assembly including a positive electrode, a negative electrode and a separator may be provided. In the assembly process, the electrode assembly and an electrolyte may be embedded in a case. In the activation process, charging, discharging, and aging may be performed on assembled battery cells. The battery cells may be activated and stabilized by electrical energy through the activation process.

[Disclosure]

[Technical Problem]

The present invention is directed to providing a secondary battery manufacturing method with improved productivity.

[Technical Solution]

Example embodiments of the present invention provide a secondary battery manufacturing method. The method includes: measuring an open circuit voltage (OCV) of a battery cell at a first time point, in which the first time point is in a range of about 24 hours to about 150 hours after charging or discharging of the battery cell; measuring the OCV of the battery cell at a second time point, in which the second time point follows the first time point; and calculating the OCV of the battery cell at a third time point, based on the OCV of the battery cell at the first time point, the OCV of the battery cell at the second time point, and an equation below.

[Equation]

$$\triangle OCV = a \times \triangle(\sqrt{t})$$

Here, $\triangle OCV$ denotes a change in the OCV between two time points, $\triangle(\sqrt{t})$ denotes a change in a square root of time between the two time points, and a is a change rate constant of the OCV.
The third time point may be in a range of 48 hours to 200 hours after the charging or discharging of the battery cell.
The method may further include calculating the OCV of the battery cell at the first time point.
The first time point may be in a range of 24 hours to 150 hours after the charging or discharging of the battery cell.
The method may further include determining quality of the battery cell, based on the calculated OCV of the battery cell at the first time point and the calculated OCV of the battery cell at the third time point.
The method may further include determining the battery cell as normal when a difference between the calculated OCV of the battery cell at the first time point and the calculated OCV of the battery cell at the third time point is in a range of 0 mV to 50 mV.
The method may further include measuring the OCV of the battery cell at the third time point.
The method may further include determining quality of the battery cell, based on the measured OCV of the battery cell at the third time point and the calculated OCV of the battery cell at the third time point.
The method may further include determining the battery cell as defective when the measured OCV of the battery cell at the third time point is lower than the calculated OCV of the battery cell at the third time point.

Example embodiments provide a secondary battery manufacturing method. The method includes: measuring an OCV of a battery cell at a first time point, in which the first time point is in a range of 12 hours to 150 hours from charging or discharging of the battery cell; measuring the OCV of the battery cell at a second time point, in which the second time point follows the first time point; and calculating a change rate constant of the OCV of the battery cell, based on the OCV of the battery cell at the first time point, the OCV of the battery cell at the second time point, and an equation below.

[Equation]

$$\triangle OCV = a \times \triangle(\sqrt{t})$$

Here, $\triangle OCV$ denotes a change in the OCV between two time points, $\triangle(\sqrt{t})$ denotes a change in a square root of time between the two time points, and a is a change rate constant of the OCV.

The method may further include determining quality of the battery cell, based on the change rate constant.

The method may further include determining the battery cell as normal when the change rate constant is in a range of -100 mV/h$^{1/2}$ to 0 mV/h$^{1/2}$.

Example embodiments provide a secondary battery manufacturing method. The method includes: measuring an OCV of a battery cell at a first time point, in which the first time point is in a range of 12 hours to 150 hours after charging or discharging of the battery cell; measuring the OCV of the battery cell at a second time point, wherein the second time point follows the first time point; and calculating the OCV of the battery cell at the first time point and the OCV of the battery cell at a third time point, based on the OCV of the battery cell at the first time point and the OCV of the battery cell at the second time point, and the OCV of the battery cell at the first time point and the OCV of the battery cell at the third time point are calculated by first-order approximation of a square root of time.

[Advantageous Effects]

According to example embodiments of the present invention, it is possible to reduce a time required for an open circuit voltage (OCV) inspection after an activation process. Accordingly, throughput and costs of the manufacture of the secondary battery may decrease.

Effects achievable from example embodiments of the present invention are not limited to the above-described effects, and other effects that are not described herein will be clearly derived and understood by those of ordinary skilled in the art to which the example embodiments of the present invention pertain from the following description. That is, unintended effects achieved when the example embodiments of the present invention are implemented are derivable by those of ordinary skilled in the art from the example embodiments of the present invention.

[Brief Description of the Drawings]

FIG. 1 is a flowchart of a secondary battery manufacturing method according to example embodiments.

FIG. 2 is a flowchart of an open circuit voltage (OCV)-based inspection of a battery cell.

FIG. 3 is a graph for describing an OCV-based inspection of a battery cell.

FIG. 4 is a graph for describing an OCV-based inspection of a battery cell.

FIG. 5 illustrates an OCV-based inspection of a battery cell according to other example embodiments.

FIG. 6 illustrates an OCV-based inspection of a battery cell according to other example embodiments.

FIG. 7 illustrates an OCV-based inspection of a battery cell according to other example embodiments.

[Best Mode]

Hereinafter, embodiments of the present invention will be described in detail with reference to the accompanying drawings. Before describing embodiments of the present invention, the terms or expressions used in the present specification and claims should not be construed as being limited to as generally understood or as defined in commonly used dictionaries, and should be understood according to meanings and concepts corresponding to the present invention on the basis of the principle that the inventor(s) of the application can appropriately define the terms or expressions to optimally explain the present invention.

Therefore, embodiments set forth herein and configurations illustrated in the drawings are only examples of the present invention and do not reflect all the technical ideas of the present invention and thus it should be understood that various equivalents and modifications that replace the configurations would have been made at the filing date of the present application.

Well-known configurations or functions related to describing the present invention are not described in detail when it is determined that they would obscure the subject matter of the present invention due to unnecessary detail.

Because embodiments of the present invention are provided to more fully explain the present invention to those of ordinary skill in the art, the shapes, sizes, etc. of components illustrated in the drawings may be exaggerated, omitted, or schematically illustrated for clarity. Therefore, it should not be understood that the sizes or proportions of components fully reflect the actual sizes or proportions thereof.

(First Embodiment)

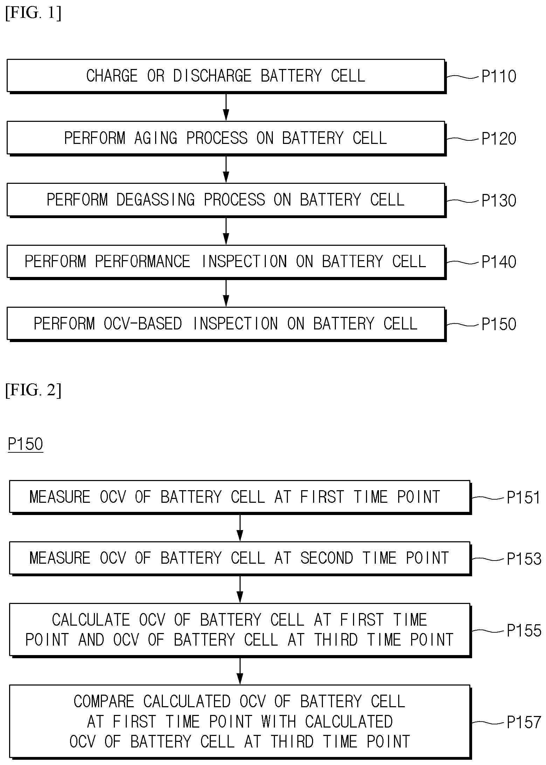

FIG. 1 illustrates a secondary battery manufacturing method according to example embodiments.

Referring to FIG. 1, in P110, a battery cell may be charged or discharged. The battery cell may be a battery cell of a secondary battery. The battery cell is a basic unit of a lithium ion battery, i.e., a secondary battery. The battery cell includes an electrode assembly, an electrolyte, and a case. Battery cells are classified into a lithium ion battery, a lithium ion polymer battery, a lithium polymer battery, etc. according to a configuration of an electrode assembly and an electrolyte. A market share of lithium ion polymer batteries in the field of secondary battery is increasing due to a low possibility of leakage of an electrolyte and easiness in manufacturing.

A battery cell is classified as a cylindrical, prismatic, or pouch type battery cell according to a shape of a battery case. A cylindrical battery includes an electrode assembly and a cylindrical metal can for accommodation of the electrode assembly therein. A prismatic battery includes an electrode assembly and a prismatic metal can for accommodation of the electrode assembly therein. The pouch type battery cell includes an electrode assembly and a pouch case for accommodation of the electrode assembly therein.

The electrode assembly may include a positive electrode, a negative electrode, and a separator between the positive electrode and the negative electrode. The electrode assembly may be classified as a jelly-roll type electrode assembly or a stack type electrode assembly according to a form of assembly. The jelly roll type electrode assembly is manufactured by winding a positive electrode, a negative electrode, and a separator interposed therebetween. The stack type electrode assembly includes a plurality of positive electrodes, a plurality of negative electrodes, and a plurality of separators interposed therebetween that are stacked sequentially.

The positive electrode may include a positive electrode current collector and a positive electrode active material. The negative electrode may include a negative electrode current collector and a negative electrode active material.

A thickness of the positive electrode current collector may range from about 3 $\mu$m to about 500 $\mu$m. The positive electrode current collector may not cause a chemical change in a finally manufactured secondary battery and may have high conductivity. The positive electrode current collector may include, for example, stainless steel, nickel, titanium, baked carbon, and aluminum. The positive electrode current collector may include stainless steel surface-treated with carbon, nickel, titanium, silver, or the like. A surface of the positive electrode current collector may include a fine uneven structure to increase the adhesion of the active material. The positive electrode current collector may be in the form of film, sheet, foil, net, porosity, foam, nonwoven fabric or the like.

A thickness of the negative electrode current collector may be in a range of about 3 $\mu$m to about 500 $\mu$m. The negative electrode current collector may not cause a chemical change in a finally manufactured secondary battery and may have high conductivity. The negative electrode current collector may include stainless steel, aluminum, nickel, titanium, baked carbon, and aluminum-cadmium alloy. The negative electrode current collector may include stainless steel surface-treated with carbon, nickel, titanium, silver, or the like. A surface of the negative electrode current collector may include a fine uneven structure to increase the adhesion of the active material. The negative electrode current collector may be in the form of film, sheet, foil, net, porosity, foam, nonwoven fabric or the like.

A positive electrode active material is a material that may cause an electrochemical reaction. The positive electrode active material may be a lithium transition metal oxide. For example, the positive electrode active material may include: a layered compound substituted with one or more transition metal, e.g., lithium cobalt oxide ($LiCoO_2$) or lithium

nickel oxide ($LiNiO_2$); lithium manganese oxide substituted with one or more transition metal; lithium nickel-based oxide expressed by a chemical formula of $LiNi_{1-y}M_yO_2$ (here, M is Co, Mn, Al, CU, Fe, Mg, B, Cr, Zn or Ga, and $0.01 \leq y \leq 0.7$); lithium nickel cobalt manganese compound oxide expressed by a chemical formula of $Li_{1+z}Ni_bMn_cCo_{1-(b+c+d)}M_dO_{(2-e)}A$, e.g., $Li_{1+z}Ni_{1/3}Co_{1/3}Mn_{1/3}O_2$ or $Li_{1+z}Ni_{0.4}Mn_{0.4}Co_{0.2}O_2$ (here, $-0.5 \leq z \leq 0.5$, $0.1 \leq b \leq 0.8$, $0.1 \leq c \leq 0.8$, $0 \leq d \leq 0.2$, $0 \leq e \leq 0.2$, b+c+d<1, M is Al, Mg, Cr, Ti, Si or Y, and A is F, P or Cl); or olivine-based lithium metal phosphate expressed by a chemical formula of $Li_{1+x}M_{1-y}M'_yPO_{4-z}X_z$ (here, M is a transition metal, and more particularly, Fe, Mn, Co or Ni, M' is Al, Mg or Ti, X is F, S or N, $-0.5 \leq x \leq +0.5$, $0 \leq y \leq 0.5$, and $0 \leq z \leq 0.1$).

A negative electrode active material may include, for example, carbon such as non-graphitized carbon or graphite-based carbon. The negative electrode active material may include, for example, a metal composite oxide such as $Li_xFe_2O_3$ ($0 \leq x \leq 1$), $LixWO_2$ ($0 \leq x \leq 1$), or $Sn_xMe_{1-x}Me'_yO_z$ (here, Me is Mn, Fe, Pb, or Ge, Me' is Al, B, P, Si, a Group I element, a Group II element or a Group III element of the periodic table, or halogen, $0 < x \leq 1$, $1 \leq y \leq 3$, and $1 \leq z \leq 8$). The negative electrode active material may include, for example, lithium metal, lithium alloy, silicon-based alloy, and tin-based alloy. The negative electrode active material may include, for example, a metal oxide such as $SnO$, $SnO_2$, $PbO$, $PbO_2$, $Pb_2O_3$, $Pb_3O_4$, $Sb_2O_3$, $Sb_2O_4$, $Sb_2O_5$, $GeO$, $GeO_2$, $Bi_2O_3$, $Bi_2O_4$, or $Bi_2O_5$. The negative electrode active material may include, for example, a conductive polymer such as polyacetylene, a Li-Co-Ni-based material, etc.

The battery cell may be provided by the electrode process and the assembly process. The electrode process may include a mixing process, a coating process, a roll pressing process, an optional slitting process, and a notching process. The assembly process may include embedding an electrode assembly in a case and additionally injecting an electrolyte into the case.

The battery cell may be pressed by a pressing jig while the battery cell is being charged or discharged. By pressing the battery cell, gas trap and lithium plating may be prevented and uniformity of a solid electrolyte interphase (SEI) film may be improved. A battery cell including a uniform SEI film may have a relatively short charging or discharging time.

An SEI film may be formed on a surface of a negative electrode by initial charging. The SEI film is a thin film generated on the surface of a negative electrode material when the battery cell is charged for the first time after the manufacture of the battery cell. When the battery cell is charged, lithium ions in the battery cell may move to the negative electrode and an SEI film may be formed on a surface of the negative electrode material due to a chemical reaction occurring when materials in the electrolyte are generated by first electrolysis during the movement of the lithium ions. The SEI may be a type of a separator. The SEI may prevent additional decomposition reaction of the electrolyte when lithium ions move from a positive electrode to the negative electrode to charge a battery.

Next, in P120, an aging process may be performed on the battery cell. In the aging process, the battery cell may be stored at room temperature for a certain time (30 minutes to 3 hours as a non-limiting example) to stabilize the charged or discharged battery cell. A key to the aging process is to uniformly disperse the electrolyte in the pouch cell so that the electrolyte may uniformly permeate both the positive electrode and the negative electrode. Mobility of lithium ions may be enhanced by the aging process.

Next, in P130, a degassing process may be performed on the battery cell. A gas may be generated inside the battery cell during charging/discharging and the aging process. In the degassing process, the gas may be removed from the inside of the battery cell.

Next, in P140, a performance inspection may be performed on the battery cell. The performance inspection may include a capacity inspection and an inspection for screening defects.

Thereafter, in P150, an open circuit voltage (OCV)-based inspection may be performed on the battery cell. A battery cell with a low-voltage defect may be sorted out by the OCV-based inspection. A low-voltage defect of a battery cell may be caused by a metal foreign material inside the battery cell. For example, when a positive electrode plate of a battery cell contains a metal foreign material such as iron or copper, the metal foreign material may grow into a dendrite on the negative electrode. The dendrite causes an undesired short circuit inside the battery cell, leading to a failure and ignition of the battery cell.

FIG. 2 is a flowchart of an OCV-based inspection of a battery cell according to example embodiments.

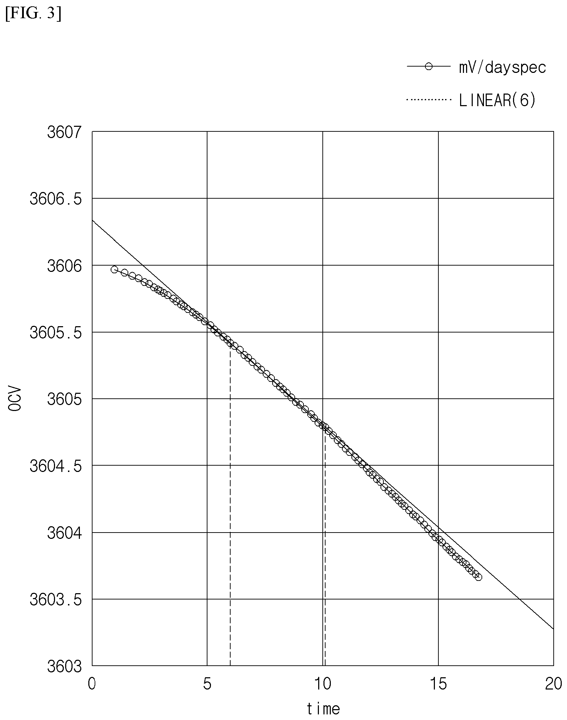

FIG. 3 is a graph for describing an OCV-based inspection of a battery cell according to example embodiments. In FIG. 3, a vertical axis represents an OCV of the battery cell, and a horizontal axis represents a square root of a time.

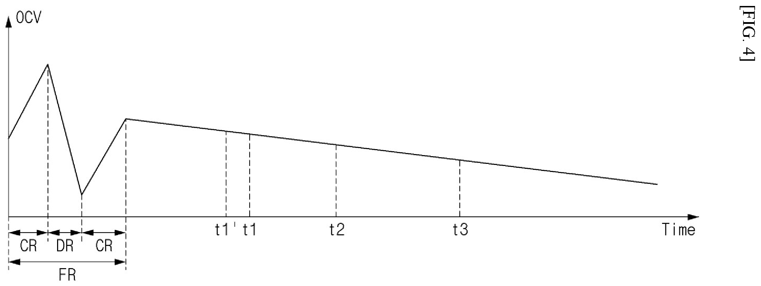

FIG. 4 is a graph for describing an OCV-based inspection of a battery cell according to example embodiments. In FIG. 4, a vertical axis represents an OCV of the battery cell, and a horizontal axis represents time.

Referring to FIGS. 2 and 3, the performing of the OCV-based inspection on the battery cell (P150) may include measuring an OCV of the battery cell at a first time point t1 (P151), measuring an OCV of the battery cell at a second time point t2 (P153), calculating an OCV of the battery cell at the first time point t1 and an OCV of the battery cell at a third time point t3 (P155), and comparing the calculated OCV of the battery cell at the first time point t1 with the calculated OCV of the battery cell at the third time point t3 (P157).

The second time point t2 may follow the first time point t1. That is, the second time point t2 may come after a certain period of time from the first time point t1. As shown in FIG. 4, an activation process FR of the battery cell may include one or more charge sections CR and one or more discharge sections DR. The first time point t1 may be within about 24 hours to about 150 hours, starting from the charging or discharging of the battery cell. The second time point t2 may follow the first time point t1. The difference between the first time point t1 and the second time point t2 may be in a range of about 0 hours to about 96 hours. As a non-limiting example, an end point of last one of the one or more charging sections CR may be a datum point of the first time point t1 and the second time point t2. Alternatively, a start point and an end point of each of the one or more charging sections CR and the one or more discharging sections DR may be a datum point of the first time point t1 and the second time point t2.

As shown in FIG. 3, in a specific section, a change in an OCV of the battery cell may approximately follow Equation 1 below. In the graph of FIG. 3, measurement-based data points are indicated by dots and an approximate expression is expressed by dashed lines.

[Equation 1]

$$OCV = a \times \sqrt{t} - b$$

In Equation 1, t denotes time, a is a change rate constant representing a rate of change of an OCV according to a square root of a time, and b is a constant representing an offset. That is, in a set section, an OCV may be first-order approximated by the square root of time. More specifically, as shown in an experimental example of FIG. 3, an OCV may be first-order approximated by the square root of time for a period of about 12 hours to about 16 days after the charging or discharging of the battery cell.

In P115, the calculating of OCVs of the battery cell at the first and third time points t1 and t3 may be based on Equation 1 above or Equation 2 below derived from Equation 1.

[Equation 2]

$$\triangle OCV = a \times \triangle(\sqrt{t})$$

In Equation 2, $\triangle OCV$ denotes a change of an OCV between two time points, $\triangle(\sqrt{t})$ denotes a change of the square root of time between the two time points, and a is a constant representing a rate of change of an OCV.

An OCV of the battery cell at a first time point t1' and the OCV of the battery cell at the third time point t3 may be calculated, based on the OCV of the battery cell measured at the first time point t1 and the OCV of the battery cell measured at the second time point t2, in addition to Equation 1 or 2. More specifically, a change rate constant and an offset constant may be determined by substituting the OCV of the battery cell measured at the first time point t1 and the OCV of the battery cell measured at the second time point t2 into Equation 1 or 2.

Here, due to a tolerance of measurement, the measured OCV at the first time point t1 may be different from that at the first time point t1' at which actual measurement is to be performed. In the present example, an OCV is measured at the first time point t1' at which actual measurement is to be performed to lift an error due to the measurement tolerance. Accordingly, when the OCV inspection is performed on a plurality of battery cells, it is possible to prevent an error in the quality of the battery cells due to randomness at a measurement time point and to improve the consistency and predictability of the manufacture of the battery cells. Because the first time point t1' and the first time point t1 are in a tolerance range, the accuracy of judgement of the quality of a battery may not be degraded regardless of the use of the calculated OCV at the first time point t1' according to example embodiments. To distinguish between the first time point t1' and the first time point t1, the first time point t1' may be referred to as an expected time point, and the first time point t1 may be referred to as an actual measurement time point.

In addition to the first time point t1', the third time point t3 may be included in a range in which first-order approximation of Equations 1 and 2 is established. The third time point t3 may follow the first and second time points t1 and t2. The third time point t3 may come after a certain period of time from the second time point t2. The third time point t3 may be in a range of about 48 hours to about 200 hours after the charging or discharging of the battery cell.

The OCV of the battery cell at the first time point t1' and the OCV of the battery cell at the third time point t3 may be calculated, based on Equation 1 or 2, the measured OCV at the first time point t1, and the measured OCV at the second time point t2. For example, the OCV of the battery cell at the first time point t1' may be calculated by determining a change rate constant and an offset constant by Equation 1 above, based on the first time point t1, the OCV of the battery cell at the first time point t1, the second time point t2, and the OCV of the battery cell at the second time point t2, and thereafter substituting the first time point t1' into Equation 1, and the OCV at the third time point t3 may be calculated by substituting the third time point t3 into Equation 1.

As another example, the OCV at the first time point t1' may be calculated by determining a change rate constant by Equation 2, based on the first time point t1, the OCV of the battery cell at the first time point t1, the second time point t2, and the OCV of the battery cell at the second battery cell t2, and thereafter substituting the first time point t1, the OCV at the first time point t1, and the first time point t1' into Equation 2, and the OCV at the third time point t3 may be calculated by substituting the first time point t1, the OCV at the first time point t1, and the third time point t3 into Equation 2.

In P157, the quality of the battery cell may be determined based on the calculated OCV of the battery cell at the first time point t1' and the calculated OCV of the battery cell at the third time point t3. For example, the battery cell may be determined as normal, when the difference between the calculated OCV of the battery cell at the first time point t1' and the calculated OCV of the battery cell at the third time point t3 is in a range of about 0 mV to about 50 mV.

Here, the OCVs may be compared with each other, based on absolute values thereof. That is, the OCVs may be compared in terms of size. Accordingly, even when polarity is changed (i.e., even when (+) and (-) electrodes of the battery cell to be measured are reversed) during measurement of an OCV, a decrease in the OCV due to a discharge may be accurately considered.

According to example embodiments, an OCV is first-order approximated by the square root of time based on OCVs measured at the first and second time points t1 and t2 after a relatively short period of time from the charging or discharging of the battery cell to reduce a time required for the OCV-based inspection of the battery cell. Accordingly, the productivity of a secondary battery may improve and production costs may decrease.

In addition, based on the above description, those of ordinary skill in the art will be able to easily derive an example in which an OCV of a battery cell at the second time point t2 rather than the first time point t1 is calculated and the quality of the battery cell is determined based on the calculated OCV of the battery cell at the second time point t2 and a calculated OCV of the battery cell at the third time point t3.

(Second Embodiment)

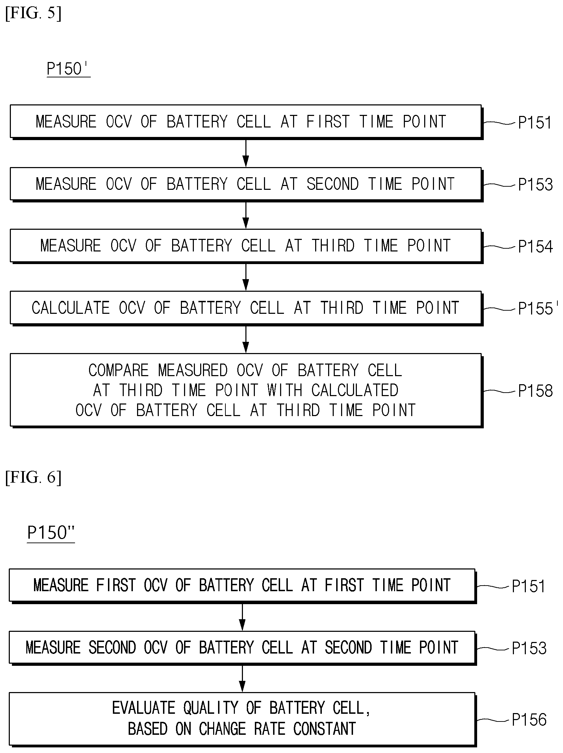

FIG. 5 illustrates an OCV-based inspection of a battery cell according to other example embodiments.

Referring to FIGS. 4 and 5, performing the OCV-based inspection on the battery cell (P150') may replace P150 of FIG. 1. The performing of the OCV-based inspection on the battery cell (P150') may include measuring an OCV of the battery cell at a first time point t1 (P151), measuring an OCV of the battery cell at a second time point t2 (P153), calculating an OCV of the battery cell at a third time point t3 (P155), measuring an OCV of the battery cell at the third time point t3 (P156), and comparing the measured OCV at the third time point t3 with the calculated OCV at the third time point t3 (P158).

Here, processes of P151 and P153 are substantially the same as those described above with reference to FIGS. 2 and 3 and a redundant description thereof is omitted here.

In P154, an OCV of the battery cell may be measured at the third time point t3. Thus, the measured OCV of the battery cell at the third time point t3 may be obtained.

P155' is substantially the same as P155 of FIG. 2 except that calculation of an OCV at a first time point t1' is omitted. In P155', in order to prevent an error due to a tolerance of measurement at the third time point t3, an OCV of the battery cell may be calculated based on a time point (i.e., a time point including the tolerance) determined by measurement of an OCV of the battery cell at the third time point t3.

Next, in P158, the quality of the battery cell may be determined based on the measured OCV of the battery cell at the third time point t3 and the calculated OCV of the battery cell at the third time point t3. For example, the battery cell may be determined as defective when the measured OCV of the battery cell at the third time point t3 is lower than the calculated OCV of the battery cell at the third time point t3. As another example, the battery cell may be determined as normal when the measured OCV of the battery cell at the third time point t3 is equal to or higher than the calculated OCV of the battery cell at the third time point t3.

(Third Embodiment)

FIG. 6 illustrates an OCV-based inspection according to other example embodiments.

Referring to FIGS. 4 and 6, performing the OCV-based inspection on the battery cell (P150") may replace P150 of FIG. 1. The performing of the OCV-based inspection on the battery cell (P150") may include measuring an OCV of the battery cell at a first time point (P151), measuring an OCV of the battery cell at a second time point t2 (P153), and evaluating the quality of the battery cell based on a change rate constant (P156).

Here, processes of P151 and P153 are substantially the same as those described above with reference to FIGS. 2 and 3 and a redundant description thereof is omitted here.

In P156, the quality of the battery cell may be evaluated based on the change rate constant. A change rate constant of an OCV relative to the square root of time may be calculated by substituting the measured OCVs at the first time point and the second time point t2 into Equation 1 or 2. For example, the battery cell may be determined as normal when the change rate constant is in a range of about -100 mV/h$^{1/2}$ to 0 mV/h$^{1/2}$. As another example, the battery cell may be determined as defective when the change rate constant is less than about - 100 mV/h$^{1/2}$.

(Fourth Embodiment)

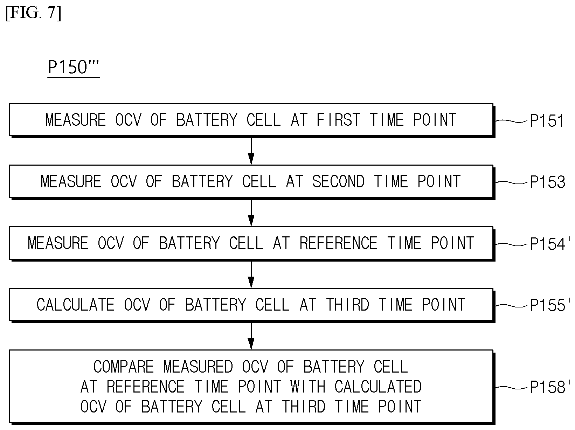

FIG. 7 illustrates an OCV-based inspection of a battery cell according to other example embodiments.

Referring to FIGS. 4 and 7, performing the OCV-based inspection on the battery cell (P150‴) may replace P150 of FIG. 1. The performing of the OCV-based inspection on the battery cell (P150') may include measuring an OCV of the battery cell at a first time point t1 (P151), measuring an OCV of the battery cell at a second time point t2 (P153), measuring an OCV of the battery cell at a reference time point (P154'), calculating an OCV of the battery cell at a third time point t3 (P155), and comparing an OCV measured at the third time point t3 with the calculated OCV at the third time point t3 (P158).

Here, processes of P151 and P153 are substantially the same as those described above with reference to FIGS. 2 and 3 and P155' is the same as that described above with reference to FIG. 5, and thus, a redundant description thereof is omitted here.

In P154', the OCV of the battery cell at the reference time point may be measured. The reference time point may follow the first and second time points t1 and t2. The reference time point may come after a certain period of time from the second time point t2. The reference time point may be different from the third time point t3. The reference time point may be earlier than the third time point t3. That is, the reference time point may be between the second time point t2 and the third time point t3. According to example embodiments, the reference time point may be in a range of 24 hours to 150 hours after the battery cell is charged or discharged.

P154' and P155' may be performed in a reverse order. That is, the OCV of the battery cell at the third time point t3 may be calculated in P155', and thereafter, the OCV of the battery cell at the reference time point may be measured in P154'.

Thereafter, in P158', the quality of the battery cell may be determined based on the measured OCV of the battery cell at the reference time point and the calculated OCV of the battery cell at the third time point t3. For example, the battery cell may be determined as normal, when the difference between the calculated OCV of the battery cell at the reference time point and the calculated OCV of the battery cell at the third time point t3 is in a range of about 0 mV to about 50 mV.

The present invention has been described above in more detail with reference to the drawings, the embodiments, etc. However, the configurations illustrated in the drawings or embodiments described in the present specification are only embodiments of the present invention and do not reflect all the technical ideas of the present invention and thus it should be understood that various equivalents and modifications that replace the configurations would have been made at the filing date of the present application.

## Claims

1. A secondary battery manufacturing method comprising:

   measuring an open circuit voltage (OCV) of a battery cell at a first time point, wherein the first time point is in a range of 24 hours to 150 hours after charging or discharging of the battery cell;
   measuring the OCV of the battery cell at a second time point, wherein the second time point follows the first time point; and
   calculating the OCV of the battery cell at a third time point, based on the OCV of the battery cell at the first time point, the OCV of the battery cell at the second time point, and an equation of:

   [Equation]

   $$\triangle OCV = a \times \triangle(\sqrt{t})$$

   wherein $\triangle OCV$ denotes a change in the OCV between two time points, $\triangle(\sqrt{t})$ denotes a change in a square root of time between the two time points, and a is a change rate constant of the OCV.

2. The secondary battery manufacturing method of claim 1, wherein the third time point is in a range of 48 hours to 200 hours after the charging or discharging of the battery cell.

3. The secondary battery manufacturing method of claim 1, further comprising calculating the OCV of the battery cell at the first time point.

4. The secondary battery manufacturing method of claim 1, wherein the first time point is in a range of 24 hours to 150 hours after the charging or discharging of the battery cell.

5. The secondary battery manufacturing method of claim 3, further comprising determining quality of the battery cell, based on the calculated OCV of the battery cell at the first time point and the calculated OCV of the battery cell at the third time point.

6. The secondary battery manufacturing method of claim 5, further comprising determining the battery cell as normal when a difference between the calculated OCV of the battery cell at the first time point and the calculated OCV of the battery cell at the third time point is in a range of 0 mV to 50 mV.

7. The secondary battery manufacturing method of claim 1, further comprising measuring the OCV of the battery cell at the third time point.

8. The secondary battery manufacturing method of claim 7, further comprising determining quality of the battery cell, based on the measured OCV of the battery cell at the third time point and the calculated OCV of the battery cell at the third time point.

9. The secondary battery manufacturing method of claim 7, further comprising determining the battery cell as defective when the measured OCV of the battery cell at the third time point is lower than the calculated OCV of the battery cell at the third time point.

10. A secondary battery manufacturing method comprising:

measuring an open circuit voltage (OCV) of a battery cell at a first time point, wherein the first time point is in a range of 12 hours to 150 hours from charging or discharging of the battery cell;
measuring the OCV of the battery cell at a second time point, wherein the second time point follows the first time point; and
calculating a change rate constant of the OCV of the battery cell, based on the OCV of the battery cell at the first time point, the OCV of the battery cell at the second time point, and an equation of:

[Equation]

$$\triangle OCV = a \times \triangle(\sqrt{t}),$$

wherein $\triangle OCV$ denotes a change in the OCV between two time points, $\triangle(\sqrt{t})$ denotes a change in a square root of time between the two time points, and a is a change rate constant of the OCV.

11. The secondary battery manufacturing method of claim 10, further comprising determining quality of the battery cell, based on the change rate constant.

12. The secondary battery manufacturing method of claim 10, further comprising determining the battery cell as normal when the change rate constant is in a range of -100 mV/h$^{1/2}$ to 0 mV/h$^{1/2}$.

13. A secondary battery manufacturing method comprising:

measuring an open circuit voltage (OCV) of a battery cell at a first time point, wherein the first time point is in a range of 12 hours to 150 hours after charging or discharging of the battery cell;
measuring the OCV of the battery cell at a second time point, wherein the second time point follows the first time point; and
calculating the OCV of the battery cell at the first time point and the OCV of the battery cell at a third time point, based on the OCV of the battery cell at the first time point and the OCV of the battery cell at the second time point,

wherein the OCV of the battery cell at the first time point and the OCV of the battery cell at the third time point are calculated by first-order approximation of a square root of time.

[FIG. 1]

```
┌────────────────────────────────────────────────┐
│      CHARGE OR DISCHARGE BATTERY CELL            │──P110
└────────────────────────────────────────────────┘
                        │
                        ▼
┌────────────────────────────────────────────────┐
│      PERFORM AGING PROCESS ON BATTERY CELL       │──P120
└────────────────────────────────────────────────┘
                        │
                        ▼
┌────────────────────────────────────────────────┐
│    PERFORM DEGASSING PROCESS ON BATTERY CELL     │──P130
└────────────────────────────────────────────────┘
                        │
                        ▼
┌────────────────────────────────────────────────┐
│  PERFORM PERFORMANCE INSPECTION ON BATTERY CELL  │──P140
└────────────────────────────────────────────────┘
                        │
                        ▼
┌────────────────────────────────────────────────┐
│   PERFORM OCV-BASED INSPECTION ON BATTERY CELL   │──P150
└────────────────────────────────────────────────┘
```

[FIG. 2]

P150

```
┌────────────────────────────────────────────────┐
│  MEASURE OCV OF BATTERY CELL AT FIRST TIME POINT │──P151
└────────────────────────────────────────────────┘
                        │
                        ▼
┌────────────────────────────────────────────────┐
│ MEASURE OCV OF BATTERY CELL AT SECOND TIME POINT │──P153
└────────────────────────────────────────────────┘
                        │
                        ▼
┌────────────────────────────────────────────────┐
│    CALCULATE OCV OF BATTERY CELL AT FIRST TIME   │
│ POINT AND OCV OF BATTERY CELL AT THIRD TIME POINT│──P155
└────────────────────────────────────────────────┘
                        │
                        ▼
┌────────────────────────────────────────────────┐
│    COMPARE CALCULATED OCV OF BATTERY CELL        │
│     AT FIRST TIME POINT WITH CALCULATED          │──P157
│    OCV OF BATTERY CELL AT THIRD TIME POINT       │
└────────────────────────────────────────────────┘
```

[FIG. 3]

[FIG. 4]

[FIG. 5]

P150'

| MEASURE OCV OF BATTERY CELL AT FIRST TIME POINT | P151 |

↓

| MEASURE OCV OF BATTERY CELL AT SECOND TIME POINT | P153 |

↓

| MEASURE OCV OF BATTERY CELL AT THIRD TIME POINT | P154 |

↓

| CALCULATE OCV OF BATTERY CELL AT THIRD TIME POINT | P155' |

↓

| COMPARE MEASURED OCV OF BATTERY CELL AT THIRD TIME POINT WITH CALCULATED OCV OF BATTERY CELL AT THIRD TIME POINT | P158 |

[FIG. 6]

P150"

| MEASURE FIRST OCV OF BATTERY CELL AT FIRST TIME POINT | P151 |

↓

| MEASURE SECOND OCV OF BATTERY CELL AT SECOND TIME POINT | P153 |

↓

| EVALUATE QUALITY OF BATTERY CELL, BASED ON CHANGE RATE CONSTANT | P156 |

[FIG. 7]

P150'''

```
┌─────────────────────────────────────────────────────────┐
│   MEASURE OCV OF BATTERY CELL AT FIRST TIME POINT         │──P151
└─────────────────────────────────────────────────────────┘
                            │
                            ▼
┌─────────────────────────────────────────────────────────┐
│   MEASURE OCV OF BATTERY CELL AT SECOND TIME POINT        │──P153
└─────────────────────────────────────────────────────────┘
                            │
                            ▼
┌─────────────────────────────────────────────────────────┐
│   MEASURE OCV OF BATTERY CELL AT REFERENCE TIME POINT     │──P154'
└─────────────────────────────────────────────────────────┘
                            │
                            ▼
┌─────────────────────────────────────────────────────────┐
│   CALCULATE OCV OF BATTERY CELL AT THIRD TIME POINT       │──P155'
└─────────────────────────────────────────────────────────┘
                            │
                            ▼
┌─────────────────────────────────────────────────────────┐
│          COMPARE MEASURED OCV OF BATTERY CELL             │
│      AT REFERENCE TIME POINT WITH CALCULATED              │──P158'
│          OCV OF BATTERY CELL AT THIRD TIME POINT          │
└─────────────────────────────────────────────────────────┘
```

## INTERNATIONAL SEARCH REPORT

| International application No. |
| --- |
| **PCT/KR2024/096241** |

| A. | CLASSIFICATION OF SUBJECT MATTER |
| --- | --- |

**G01R 31/385**(2019.01)i; **G01R 19/165**(2006.01)i; **H01M 10/42**(2006.01)i; **H01M 10/44**(2006.01)i; **H01M 10/04**(2006.01)i

According to International Patent Classification (IPC) or to both national classification and IPC

| B. | FIELDS SEARCHED |
| --- | --- |

Minimum documentation searched (classification system followed by classification symbols)

G01R 31/385(2019.01); G01R 31/36(2006.01); G01R 31/367(2019.01); G01R 31/382(2019.01); G01R 31/392(2019.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 시간(time), OCV, 제곱근(square root), 변화량(variance)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | KR 10-2022-0139755 A (LG ENERGY SOLUTION, LTD.) 17 October 2022 (2022-10-17) <br> See paragraphs [0040]-[0048] and figure 1. | 1-13 |
| A | KR 10-2021-0080068 A (LG ENERGY SOLUTION, LTD.) 30 June 2021 (2021-06-30) <br> See paragraphs [0024]-[0053] and figures 2-7. | 1-13 |
| A | KR 10-2022-0039452 A (LG ENERGY SOLUTION, LTD.) 29 March 2022 (2022-03-29) <br> See claims 1-10 and figure 2. | 1-13 |
| A | KR 10-2017-0116427 A (LG CHEM, LTD.) 19 October 2017 (2017-10-19) <br> See claims 1-15 and figure 4. | 1-13 |
| A | JP 2021-150220 A (FURUKAWA ELECTRIC CO., LTD. et al.) 27 September 2021 (2021-09-27) <br> See claims 1-7 and figure 1. | 1-13 |

☐ Further documents are listed in the continuation of Box C.     ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **13 January 2025** | **13 January 2025** |

| Name and mailing address of the ISA/KR | Authorized officer |
| --- | --- |
| **Korean Intellectual Property Office** <br> **Government Complex-Daejeon Building 4, 189 Cheongsa-** <br> **ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.

**PCT/KR2024/096241**

| Patent document cited in search report | | | Publication date (day/month/year) | Patent family member(s) | | | Publication date (day/month/year) |
|---|---|---|---|---|---|---|---|
| KR | 10-2022-0139755 | A | 17 October 2022 | CN | 115803937 | A | 14 March 2023 |
| | | | | EP | 4199182 | A1 | 21 June 2023 |
| | | | | JP | 2023-530691 | A | 19 July 2023 |
| | | | | JP | 7537664 | B2 | 21 August 2024 |
| | | | | US | 2023-0296688 | A1 | 21 September 2023 |
| | | | | WO | 2022-215962 | A1 | 13 October 2022 |
| KR | 10-2021-0080068 | A | 30 June 2021 | EP | 4016099 | A1 | 22 June 2022 |
| | | | | JP | 2022-548918 | A | 22 November 2022 |
| | | | | JP | 7436114 | B2 | 21 February 2024 |
| | | | | US | 2022-0357404 | A1 | 10 November 2022 |
| | | | | WO | 2021-125674 | A1 | 24 June 2021 |
| KR | 10-2022-0039452 | A | 29 March 2022 | CN | 115087878 | A | 20 September 2022 |
| | | | | EP | 4083644 | A1 | 02 November 2022 |
| | | | | KR | 10-2707237 | B1 | 20 September 2024 |
| | | | | US | 12025673 | B2 | 02 July 2024 |
| | | | | US | 2023-0084079 | A1 | 16 March 2023 |
| | | | | WO | 2022-065636 | A1 | 31 March 2022 |
| KR | 10-2017-0116427 | A | 19 October 2017 | KR | 10-2040880 | B1 | 05 November 2019 |
| JP | 2021-150220 | A | 27 September 2021 | JP | 7449738 | B2 | 14 March 2024 |

Form PCT/ISA/210 (patent family annex) (July 2022)

**EP 4 756 451 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230137347